# EUROPÄISCHE PATENTSCHRIFT

(11) **EP 3 562 276 B1**
(45) Veröffentlichungstag und Bekanntmachung des Hinweises auf die Patenterteilung: **30.12.2020**
(21) Anmeldenummer: 18168814.4
(22) Anmeldetag: 23.04.2018
(51) Int. Cl.: H05H 1/24, C02F 1/46

(54) **VORRICHTUNG ZUR PLASMAGESTÜTZTEN BEHANDLUNG VON FLÜSSIGKEITEN**
DEVICE FOR PLASMA-SUPPORTED TREATMENT OF LIQUIDS
DISPOSITIF DE TRAITEMENT DE LIQUIDES ASSISTÉ PAR PLASMA

(43) Veröffentlichungstag der Anmeldung: 30.10.2019
(73) Patentinhaber: Leibniz-Institut für Plasmaforschung und Technologie e.V., 17489 Greifswald (DE)
(72) Erfinder: WELTMANN, Klaus-Dieter, 18609 Ostseebad Binz (DE); BRANDENBURG, Ronny, 17495 Groß Kiesow OT Kessin (DE); STIEBER, Manfred, 17489 Greifswald (DE); HORN, Stefan, 17509 Loissin (DE); SCHMIDT, Michael, 17489 Greifswald (DE); VON WOEDTKE, Thomas, 18519 Sundhagen (DE); WINTER, Jörn, 17489 Greifswald (DE)
(74) Vertreter: Schulz Junghans Patentanwälte PartGmbB

(56) Entgegenhaltungen:
- EP-A1- 2 153 851
- WO-A1-2006/116828
- JP-A- 2002 126 769
- JP-A- 2012 227 149
- KR-A- 20120 097 138
- US-A1- 2017 362 107
- BUBNOV A G ET AL: "Plasma-Catalytic Decomposition of Phenols in Atmospheric Pressure Dielectric Barrier Discharge", PLASMA CHEMISTRY AND PLASMA PROCESSING, KLUWER ACADEMIC PUBLISHERS-PLENUM PUBLISHERS, NE, Bd. 26, Nr. 1, 1. Februar 2006 (2006-02-01), Seiten 19-30, XP019290303, ISSN: 1572-8986
- OGNIER S ET AL: "Analysis of Mechanisms at the Plasma-Liquid Interface in a Gas-Liquid Discharge Reactor Used for Treatment of Polluted Water", PLASMA CHEMISTRY AND PLASMA PROCESSING, KLUWER ACADEMIC PUBLISHERS-PLENUM PUBLISHERS, NE, Bd. 29, Nr. 4, 9. Juni 2009 (2009-06-09), Seiten 261-273, XP019732878, ISSN: 1572-8986, DOI: 10.1007/S11090-009-9179-X

## Beschreibung

Die Erfindung betrifft eine Vorrichtung zur Plasmabehandlung von Flüssigkeiten und Flüssigkeitsfilmen.

Vorrichtungen und Verfahren zur Behandlung von Oberflächen mittels Niedertemperaturplasmen unter Atmosphärendruckbedingungen haben sich bereits seit vielen Jahren für vielfältige industrielle Anwendungen etabliert.

Inzwischen wurden auch neue Applikationsmöglichkeiten von Atmosphärendruck-Plasmen in einigen Bereichen der Biologie und Medizin erschlossen, was dazu geführt hat, dass sich beispielsweise international die "Plasmamedizin" als ein neues, eigenständiges Fachgebiet entwickelt hat. Sowohl für die Plasmamedizin, als auch für die Trinkwasser- und Abwasseraufbereitung spielen Wechselwirkungen zwischen Atmosphärendruck-Plasmen und Flüssigkeiten eine wesentliche Rolle, die daher in zahlreichen wissenschaftlichen Studien unter verschiedenen Aspekten umfassend untersucht werden. Eine Übersicht über derartige Untersuchungen bietet der wissenschaftliche Fachartikel "Plasma-liquid interactions: a review and roadmap" (Bruggeman P J, Kushner M J, Locke B R, et al., Plasma science and technology 2016 25 053002).

Darüber hinaus werden in der Fach- und Patentliteratur Anordnungen und Verfahren zur Plasmabehandlung von Flüssigkeiten beschrieben, die auf der Anwendung verschiedener Arten von Plasmaquellen basieren.

Einen Überblick über die aus dem Stand der Technik bekannten Lösungen gibt der Fachartikel "Electrical discharge in water treatment technology for micropollutant decomposition" (Vanraes P, Nikiforov A, Leys C, Plasma science and technology: progress in physical states and chemical reactions 2016 457).

In dem vorgenannten Übersichtsartikel werden unter anderem Vorrichtungen, die in Form eines sogenannten "Wasserfall-Reaktors" bzw. "Wasserfilm-Reaktors" ausgebildet sind, beschrieben.

Prinzipiell handelt es sich bei diesen Vorrichtungen um lotrechte, koaxiale Anordnungen zur Erzeugung einer dielektrisch behinderten Entladung (DBE; auch bekannt als *DBD*: *Dielectric Barrier Discharge*), wobei in dem Entladungsraum das mit dem Plasma zu behandelnde Wasser als Wasserfilm über die Oberfläche einer der beiden konzentrisch angeordneten Elektroden geleitet wird, so dass die reaktiven Spezies, die im Plasma, das über der Wasserfilm-Oberfläche erzeugt ist, gebildet werden, direkt auf den Wasserfilm wirken können.

Unterschiedliche Ausführungsformen dieser Art einer Vorrichtung zur Behandlung einer Flüssigkeit ergeben sich dabei im Wesentlichen durch verschiedene Elektrodenanordnungen sowie durch die Anordnung des zu behandelnden Wasserfilms.

Diese Art "Wasserfilm-Reaktor" wurde in erster Linie für den Abbau von mit konventionellen Methoden schwer abbaubaren Schadstoffen im Wasser konzipiert.

Um einen effektiven Schadstoffabbau erzielen zu können, muss das zu behandelnde Wasser dabei in der Regel mehrfach durch den "Wasserfilm-Reaktor" geleitet werden.

Ein Plasmareaktor dieser Art wird beispielsweise in dem Fachartikel von B.P. Dojčinović und Kollegen (Dojčinović B P et al., "Decolorization of reactive textile dyes using water falling film dielectric barrier discharge", Journal of Hazardous Materials 192 2011763) beschrieben.

Die Druckschrift JP 2012 227149 A offenbart eine Plasmavorrichtung zur Erzeugung von reaktiven Gasspezies. Die Vorrichtung ist dazu eingerichtet, von einer Flüssigkeit umströmt oder in eine Flüssigkeit eingetaucht zu werden, und im Betrieb ein Plasma in einem Entladungsraum zu erzeugen, so dass im Entladungsraum besagte reaktive Gasspezies erzeugt werden. Dieses Reaktivgas strömt sodann durch eine poröse Wandung und eine Masseelektrode, um in der umgebenden Flüssigkeit in Form von feinen Blasen die Flüssigkeit zu reinigen bzw. zu desinfizieren.

In diesem Zusammenhang offenbart die Druckschrift JP 2002 126769 eine ähnliche Einrichtung zur Reinigung und zur desinfizierenden Behandlung von Wasser wie JP 2012 227149 A. Reinigung und Desinfektion funktionieren nach dem gleichen Prinzip, nämlich dass ein in einem Entladungsraum erzeugtes Reaktivgas durch eine poröse Wandung strömt und dort in Form von feinen Blasen die vorbeiströmende Flüssigkeit durchsetzt und so die Flüssigkeit desinfiziert und gereinigt wird.

Bubnov, A G et al. "Plasma-Catalytic Decomposition of Phenols in Atmospheric Pressure Dielectric Barrier Discharge", Plasma Chemistry and Plasma Processing, Kluwer Academic publishers-Plenum Publishers, NE, Bd. 26, Nr. 1, 1. Februar 2006 (2006-02-01), Seiten 19-30, SSN: 1572-8986 offenbart eine Vorrichtung zur Behandlung einer Flüssigkeit mit einem Plasma, die eine koaxiale Bauweise aufweist, mit einer Hochspannungselektrode, einer flüssigkeitsundurchlässigen Masseelektrode, einem Dielektrikum, und einer porösen Oberfläche, die auf der Hochspannungselektrode angeordnet ist. Die Vorrichtung bildet einen Entladungsraum aus, der sich zwischen der porösen Oberfläche der Hochspannungselektrode und der Masseelektrode befindet. Durch den Entladungsraum wird über eine Öffnung eine Flüssigkeit über die poröse Oberfläche der Hochspannungselektrode geströmt, so dass die zu behandelnde Flüssigkeit im Entladungsraum dem Plasma ausgesetzt wird. Aufgrund des hier beschriebenen prinzipiellen Aufbaus dieser Reaktoren und deren Handhabung sind diese nur bedingt für die Desinfektion von Leitungswasser direkt hinter dem Auslaufhahn einer Wasserleitung nutzbar. Weiterhin eignen sich diese Reaktoren nicht zur Erzeugung von plasmabehandeltem Wasser für eine effektive Desinfektion von Oberflächen.

Mit der erfindungsgemäßen Vorrichtung werden diese angestrebten Anwendungen und Zielstellungen erreicht bzw. die Bedingungen dafür wesentlich verbessert.

Die Aufgabe der vorliegenden Erfindung ist es, eine Vorrichtung zur Behandlung einer Flüssigkeit, insbesondere von Wasser, mit einem Plasma zur Verfügung zu stellen, welche platzsparend und effektiv eine Plasmabehandlung einer Flüssigkeit ermöglicht. Das Problem wird durch die Vorrichtung zur Behandlung einer Flüssigkeit mit einem Plasma nach Anspruch 1 gelöst. Vorteilhafte Ausgestaltungen der Vorrichtung sind in den Unteransprüchen angegeben. Ein System zur Behandlung einer Flüssigkeit mit einem Plasma ist in Anspruch 15 angegeben. Diese und weitere Ausführungsformen werden nachfolgend beschrieben.

Ein erster Aspekt der Erfindung betrifft eine Vorrichtung zur Behandlung einer Flüssigkeit mit einem Plasma, wobei die Vorrichtung eine Hochspannungselektrode sowie eine flüssigkeitsdurchlässige Masseelektrodenvorrichtung aufweist. Die Masseelektrodenvorrichtung umfasst einen flächigen, leitfähigen Bereich und einen an dem flächigen, leitfähigen Bereich angrenzenden porösen Bereich, wobei der leitfähige Bereich entlang seiner flächigen Ausdehnung flüssigkeitsdurchlässig ist.

Zwischen der Masseelektrodenvorrichtung und der Hochspannungselektrode ist ein Entladungsraum ausgebildet, in dem ein Plasma zur Behandlung der Flüssigkeit erzeugt werden kann.

Zur Erzeugung eines nicht-thermischen Plasmas unter Atmosphärendruck mittels dielektrisch behinderter Entladung ist in dem Entladungsraum mindestens auf der Hochspannungselektrode ein als dielektrische Barriere fungierender Isolator (Dielektrikum) insbesondere flächig angeordnet, nämlich das erste Dielektrikum.

Darunter ist insbesondere zu verstehen, dass zumindest ein Bereich des ersten Dielektrikums in Kontakt zu der Hochspannungselektrode steht. Das erste Dielektrikum ist insbesondere derart im Bezug zur Hochspannungselektrode positioniert, dass das erste Dielektrikum zwischen der Hochspannungselektrode und der Masseelektrodenvorrichtung, insbesondere dem leitfähigen Bereich der Masseelektrodenvorrichtung, angeordnet ist. Der poröse Bereich der Masseelektrodenvorrichtung kann dielektrisch sein, so dass der poröse Bereich als das Dielektrikum fungieren kann.

Zusätzlich kann die Masseelektrodenvorrichtung ein zweites Dielektrikum aufweisen und/oder an einem zweiten Dielektrikum angeordnet sein. Insbesondere ist vorgesehen, dass der poröse Bereich der Masseelektrodenvorrichtung dielektrisch sein kann, so dass der poröse Bereich als zweites Dielektrikum fungieren kann. In der Ausführungsform, in der ein zweites Dielektrikum an der Masseelektrodenvorrichtung angeordnet ist, ist es erforderlich, dass das zweite Dielektrikum flüssigkeitsdurchlässig ist.

Weiterhin weist die Vorrichtung erfindungsgemäß ein Vorlaufvolumen auf, in das die Flüssigkeit zum Beispiel über einen Flüssigkeitsregler, wie einen Wasserhahn, einleitbar ist. Das Vorlaufvolumen ist von einer Wandung umfasst.

Die Wandung des Vorlaufvolumens weist zumindest in einem ersten Bereich die Masseelektrodenvorrichtung auf, so dass das Vorlaufvolumen mit dem Entladungsraum über die Masseelektrodenvorrichtung flüssigkeitsdurchlässig verbunden ist.

Insbesondere sind die Hochspannungselektrode, das erste Dielektrikum und der leitfähige Bereich der Masseelektrodenvorrichtung flächig ausgebildet und gegenüberliegend am Entladungsraum angeordnet, so dass die Vorrichtung insbesondere zur Erzeugung einer sogenannten dielektrisch behinderten Volumen-Entladung (Volumen-DBE) geeignet ist.

Insbesondere ist die erfindungsgemäße Vorrichtung so ausgebildet, dass die Flüssigkeit vom Vorlaufvolumen nur durch die Masseelektrodenvorrichtung hindurch in den Entladungsraum dringen kann, es also insbesondere keine weitere flüssigkeitsdurchlässige Verbindung zwischen dem Entladungsraum und dem Vorlaufvolumen gibt. Dadurch wird ein besonders homogener Flüssigkeitsfilm erzeugt, der gut mit dem im Entladungsraum erzeugten Plasma behandelt werden kann.

Weiterhin ist erfindungsgemäß vorgesehen, dass im Betrieb der Vorrichtung die in das Vorlaufvolumen eingeleitete Flüssigkeit durch die Masseelektrodenvorrichtung dringt und auf eine Oberfläche der Masseelektrodenvorrichtung strömt, die dem Entladungsraum zugewandt ist. Es bildet sich auf dieser Oberfläche ein Flüssigkeitsfilm aus, auf den das Plasma großflächig wirken kann.

Das Vorlaufvolumen weist insbesondere einen Zulauf auf, über den die Flüssigkeit dem Vorlaufvolumen zugeführt werden kann.

Masseelektrodenvorrichtung zu erzeugen, der über die gesamte Ausdehnung dieser Oberfläche dem im Entladungsraum erzeugten Plasma ausgesetzt wird.

Im Unterschied zu "Wasserfilm-Reaktoren" aus dem Stand der Technik wird das zu behandelnde Wasser bei der erfindungsgemäßen Vorrichtung insbesondere nicht direkt als Wasserfilm über die Oberfläche der Elektroden geleitet, sondern durch die Masseelektrodenvorrichtung hindurch in den Entladungsraum auf deren Oberfläche geleitet.

Dies bewirkt insbesondere eine gleichmäßige Ausbildung des Wasserfilms auf der Masseelektrodenvorrichtung. Weiterhin wird das Wasser insbesondere durch den porösen Bereich der Massenelektrodenvorrichtung gefiltert.

Dabei ist die gesamte Durchtrittsfläche des porösen Bereichs der Massenelektrodenvorrichtung für die Flüssigkeit vergleichsweise groß gegenüber Lösungen aus dem Stand der Technik, die lediglich einige wenige Verbindungsöffnungen zu einem Entladungsraum aufweisen.

Mit dem porösen Bereich wird ein poriger, durchlässiger Bereich bezeichnet, insbesondere ein Bereich, der eine Vielzahl an kleinen Löchern, Kanälen und/oder Kapillaren aufweist.

Gemäß einer Ausführungsform der Erfindung ist die Masseelektrodenvorrichtung derart ausgebildet und positioniert, dass der leitfähige Bereich zumindest auf einer dem Vorlaufvolumen zugewandten Seite der Wandung angeordnet ist, und der poröse Bereich zumindest auf einer dem Entladungsraum zugewandten Seite angeordnet ist.

Der poröse Bereich der Masseelektrodenvorrichtung weist beispielsweise ein Isoliermaterial auf, wobei der poröse Bereich insbesondere aus einem Isoliermaterial, beispielsweise aus keramischem Material, besteht, so dass die Vorrichtung zwei Dielektrika, nämlich das erste und das zweite Dielektrikum, aufweist, zwischen denen der Entladungsraum ausgebildet ist.

Die Verwendung einer Masseelektrodenvorrichtung, die einen porösen keramischen Bereich aufweist, der als zweites Dielektrikum fungieren kann, hat den Vorteil, dass sich im Entladungsraum im Vergleich zu einer Ausführungsform ohne das zweite Dielektrikum ein homogeneres, weniger stark filamentiertes Plasma ausbilden kann und damit eine gleichmäßigere Behandlung des Wasserfilms möglich wird.

Alternativ kann die Struktur des porösen Bereichs im Wesentlichen nur unverzweigte Kanäle oder Kapillaren aufweisen, die den porösen Bereich durchdringen und sich zwischen dem Vorlaufvolumen und dem Entladungsraum erstrecken.

Gemäß einer weiteren Ausführungsform der Erfindung weist der Entladungsraum mindestens eine Austrittsöffnung für die Flüssigkeit auf, durch die die Flüssigkeit nach einer Behandlung mit dem Plasma aus der Vorrichtung hinausgeführt werden kann.

Gemäß einer Ausführungsform der Erfindung ist vorgesehen, dass die Masseelektrodenvorrichtung mindestens drei Kanäle aufweist, die den Entladungsraum und das Vorlaufvolumen miteinander flüssigkeitsdurchlässig verbinden.

Eine weitere Ausführungsform der Erfindung sieht vor, dass der flächige, leitfähige Bereich der Masseelektrodenvorrichtung eine Vielzahl an Ausnehmungen aufweist, die an den porösen Bereich angrenzen.

Eine Ausnehmung ist beispielsweise ein Loch.

Insbesondere ist erfindungsgemäß vorgesehen, dass der flächige, leitfähige Bereich der Masseelektrodenvorrichtung mehr als zwei Ausnehmungen aufweist, wobei jede Ausnehmung den leitfähigen Bereich von der dem Vorlaufvolumen zugewandten Seite zu der an den porösen Bereich angrenzenden Seite durchdringt.

Eine weitere Ausführungsform der Erfindung sieht vor, dass der flächige, leitfähige Bereich der Masseelektrodenvorrichtung eine perforierte oder eine gitterartige oder eine textile Struktur oder eine poröse Struktur aufweist.

Eine gitterartige Struktur ist insbesondere eine regelmäßige oder quasiregelmäßige Gitterstruktur.

Eine textile Struktur weist insbesondere Fasern auf, die zu einem Gewebe zusammengefügt sind, beispielsweise durch spinnen oder weben. Die textile Struktur umfasst erfindungsgemäß insbesondere leitfähige Fasern.

Insbesondere weist der flächige leitfähige Bereich der Masseelektrodenvorrichtung ein elektrisch leitfähiges Textil auf oder besteht aus einem elektrisch leitfähigen Textil. Gemäß einer Ausführungsform der Erfindung ist vorgesehen, dass der flächige, leitfähige Bereich der Masseelektrodenvorrichtung eine leitfähige Gaze, insbesondere eine Metallgaze, aufweist oder aus der Gaze besteht.

Insbesondere leitfähige Textile sowie leitfähige Gazen können einfach in die erforderliche Form für die Masseelektrodenvorrichtung gebracht werden, z.B. durch Biegen, so dass eine einfache und günstige Herstellung der Masseelektrodenvorrichtung möglich ist.

Eine weitere Ausführungsform der Erfindung sieht vor, dass der poröse Bereich der Masseelektrodenvorrichtung leitfähig und leitfähig mit dem leitfähigen Bereich verbunden oder einstückig mit dem leitfähigen Bereich ausgeformt ist.

Während der poröse Bereich der Masseelektrodenvorrichtung im Allgemeinen nicht leitfähig ausgestaltet sein muss, ist dies gemäß dieser Ausführungsform jedoch explizit vorgesehen.

Eine Variante der obigen Ausführungsform sieht demnach vor, dass der poröse Bereich und der leitfähige Bereich einstückig ausgeformt sind. Das bedeutet, dass in dieser Ausführungsform der poröse Bereich und der leitfähige Bereich in einem zusammenhängenden Stück aus demselben Material ausgebildet sind.

Alternativ ist vorgesehen, dass der leitfähige Bereich und der poröse Bereich aus zwei verschiedenen Teilen bestehen, die jedoch leitfähig miteinander verbunden sind.

Gemäß einer weiteren Ausführungsform der Erfindung weist der poröse Bereich der Masseelektrodenvorrichtung ein Isoliermaterial auf, insbesondere ein zweites Dielektrikum, insbesondere einen kristallinen, teilkristallinen oder einen keramischen Stoff. In einer alternativen Ausführungsform besteht der poröse Bereich der Masseelektrodenvorrichtung aus solch einem Stoff.

Erfindungsgemäß ist demnach vorgesehen, dass der leitfähige Bereich beispielsweise an einem keramischen Bereich angeordnet oder von dem keramischen Bereich umgeben ist.

Ein kristalliner Stoff weist eine regelmäßige Struktur auf. Ein teilkristalliner Stoff umfasst kristalline und amorphe Bereiche. In einem amorphen Bereich ist keine regelmäßige Struktur ausgebildet. Ein keramischer Stoff ist kristallin, insbesondere polykristallin. Das bedeutet, dass er eine Vielzahl von Einzelkristallen aufweist.

Gemäß einer weiteren Ausführungsform der Erfindung ist die Vorrichtung dazu eingerichtet, dass der poröse Bereich als Flüssigkeitsfilter ausgebildet ist, so dass eine durch den porösen Bereich hindurchtretende Flüssigkeit gefiltert wird.

Insbesondere können durch den Flüssigkeitsfilter Feststoffpartikel, wie beispielsweise Mikroplastik, aus der Flüssigkeit herausgefiltert werden. Dadurch ermöglicht die erfindungsgemäße Vorrichtung einen zusätzlichen Behandlungsschritt einer Flüssigkeit, der der Plasmabehandlung der Flüssigkeit vorhergeht.

Je nach Porengröße des porösen Bereichs werden ausschließlich größere oder auch kleinere Partikel aus der Flüssigkeit gefiltert. Insbesondere sind Poren mit einem Durchmesser zwischen 100 nm und 1000 nm erfindungsgemäß. Die Erfindung ist jedoch nicht auf Poren dieser Durchmesser beschränkt.

Gemäß einer weiteren Ausführungsform der Erfindung ist vorgesehen, dass die Wandung rotationssymmetrisch oder achssymmetrisch entlang einer Erstreckungsrichtung des Vorlaufvolumens ausgebildet ist.

Eine weitere Ausführungsform der Erfindung sieht vor, dass die Wandung des Vorlaufvolumens zylindrisch oder konisch ausgebildet ist, insbesondere wobei die Wandung in einem umlaufenden Bereich des Zylindermantels oder des Konus aus der Masseelektrodenvorrichtung besteht.

Die konische Form umfasst sowohl die Form eines Kegels als auch die Form eines Kegelstumpfes oder ähnliche sich verjüngende oder verbreiternde Formkonturen.

Die Grundfläche des Zylinders oder des Konus ist insbesondere kreisförmig oder elliptisch. Die Erfindung umfasst insbesondere gerade Zylinder oder gerade Konen, ist jedoch nicht auf diese beschränkt.

Eine weitere Ausführungsform der Erfindung sieht vor, dass die Masseelektrodenvorrichtung und die Hochspannungselektrode koaxial angeordnet sind.

Gemäß dieser Ausführungsform der Erfindung ist die Hochspannungselektrode insbesondere radial und parallel zur Masseelektrodenvorrichtung um diese herum angeordnet oder bereichsweise gegenüber angeordnet.

Der Entladungsraum, der zwischen der Hochspannungselektrode und der Masseelektrodenvorrichtung liegt, ist damit auch koaxial angeordnet, ebenso wie das erste Dielektrikum.

Das Vorlaufvolumen ist gemäß dieser Ausführungsform im Inneren der Masseelektrodenvorrichtung angeordnet. Durch das Vorlaufvolumen verläuft die gemeinsame Achse der koaxial angeordneten Komponenten.

Nach außen ist die Hochspannungselektrode insbesondere von einem Isolator, der beispielsweise durch ein Acrylrohr ausgebildet ist, umgeben.

In einer alternativen koaxialen Ausführungsform ist die Masseelektrodenvorrichtung insbesondere radial und parallel zur Hochspannungselektrode um diese herum angeordnet oder bereichsweise gegenüber angeordnet.

Bei dieser koaxialen Variante verläuft die gemeinsame Achse der koaxialen Komponenten durch die Hochspannungselektrode.

Das Vorlaufvolumen umfasst gemäß dieser erfindungsgemäßen Ausführungsform die Masseelektrodenvorrichtung von außen.

Den koaxialen Ausführungsformen der Erfindung kann eine Flüssigkeit in das Vorlaufvolumen zugeführt werden. Die Flüssigkeit tritt durch die Masseelektrodenvorrichtung hindurch in den Entladungsraum und bildet an der dem Vorlaufvolumen abgewandten Seite der Masseelektrodenvorrichtung im Entladungsraum einen Flüssigkeitsfilm aus, der an der Oberfläche der Masseelektrodenvorrichtung hinabfließt und dem Plasma ausgesetzt werden kann.

Alternativ kann die Vorrichtung derart angeordnet werden, dass die Flüssigkeit dem Vorlaufvolumen von unten zugeführt wird.

Der koaxiale Aufbau der erfindungsgemäßen Vorrichtung ermöglicht eine kompakte, d.h. eine platzsparende Bauweise.

Die koaxialen Ausführungsformen können beispielsweise an einen Wasserhahn zur Wasserreinigung angeordnet werden.

Im bestimmungsgemäßen Zustand der koaxialen Ausführungsformen ist insbesondere vorgesehen, dass die Masseelektrodenvorrichtung und die Hochspannungselektrode koaxial entlang einer lotrechten Erstreckungsrichtung der Vorrichtung verlaufen.

Gemäß einer alternativen, nicht-koaxialen Ausführungsform der Erfindung ist vorgesehen, dass die Masseelektrodenvorrichtung an einem planaren Bereich der Wandung angeordnet ist, wobei die Masseelektrodenvorrichtung planar ausgebildet ist.

Erfindungsgemäß ist die Hochspannungselektrode im Wesentlichen planparallel zur Masseelektrodenvorrichtung angeordnet. Insbesondere ist die Hochspannungselektrode oberhalb der Masseelektrodenvorrichtung positioniert.

In diesem Fall wird die Flüssigkeit aus dem Vorlaufvolumen nach oben durch die Masseelektrodenvorrichtung in den Entladungsraum gedrückt. Dort bildet sie den Flüssigkeitsfilm aus, der dem Plasma ausgesetzt ist.

Der Betrieb der Vorrichtung gemäß dieser Ausführungsform ist nicht an eine lotrechte Einbaulage gebunden. In dieser erfindungsgemäßen Ausführungsform ist auch ein Betrieb in waagerechter Einbaulage möglich.

Eine weitere Ausführungsform der Erfindung sieht vor, dass die Vorrichtung eine Arbeitsgasöffnung aufweist, durch die ein gasförmiges Medium in den Entladungsraum geleitet werden kann. Dabei weist die Arbeitsgasöffnung insbesondere einen Anschluss auf, an den eine Gasquelle an die Vorrichtung angeschlossen werden kann.

Die Arbeitsgasöffnung ist insbesondere derart angeordnet, dass sie den Entladungsraum direkt mit der Gasquelle verbindet. Über die Arbeitsgasöffnung kann ein Arbeitsgas direkt in den Entladungsraum eingeleitet werden.

Alternativ ist die Arbeitsgasöffnung insbesondere so angeordnet, dass ein Einleiten des Arbeitsgases in den Bereich der Masseelektrodenvorrichtung erfolgt. Durch die Masseelektrodenvorrichtung gelangt das Arbeitsgas in den Entladungsraum.

Das Arbeitsgas kann beispielsweise Umgebungsluft oder ein von einer thermischen Plasmaquelle erzeugtes Plasmagas sein.

Vorteilhaft ermöglicht diese erfindungsgemäße Ausführungsform, dass zusätzlich zu der zu behandelnden Flüssigkeit ein Gas durch die poröse Elektrode oder direkt in den Entladungsraum geleitet wird.

Beispielsweise wird auf diese Weise das Plasmagas aus einer weiteren Atmosphärendruck-Plasmaquelle mit einem thermischen oder einem nicht-thermischen Plasma in die Vorrichtung eingeleitet.

Insbesondere in thermischen Plasmaquellen, wie beispielsweise in einer DC-Plasmajet-Anordnung (DC: *direct current;* Gleichstrom), wird ein Gasgemisch mit einer hohen Konzentration von reaktiven Stickstoffspezies erzeugt.

Ein Einführen eines solchen Plasmagases in den Entladungsraum der erfindungsgemäßen Vorrichtung ermöglicht das Einbringen von Stickstoff-Verbindungen in die zu behandelnde Flüssigkeit.

Wasser, das auf diese Weise behandelt wurde, kann zur Optimierung von Wachstumsprozessen und zur Ertragssteigerung im Gartenbau und in der Landwirtschaft eingesetzt werden.

Gemäß einer Ausführungsform der Erfindung ist vorgesehen, dass die Vorrichtung eine Ultraviolett-Strahlungsquelle (UV-Strahlungsquelle) oder ein Anschlussmittel für eine UV-Strahlungsquelle aufweist, wobei die UV-Strahlungsquelle derart positioniert oder über das Anschlussmittel positionierbar ist, dass die UV-Strahlung auf die Flüssigkeit trifft. Insbesondere ist vorgesehen, dass die UV-Strahlung auf die Flüssigkeit trifft, nachdem die Flüssigkeit durch das Plasma behandelt wurde.

Die UV-Strahlungsquelle sendet insbesondere elektromagnetische Strahlung im Wellenlängenbereich von 100 nm bis 400 nm aus.

Kurzwellige UV-Strahlung im Bereich der sogenannten UV-C-Strahlung, definiert als Strahlung mit einer Wellenlänge von 100 nm bis 280 nm, kann zur Trinkwasserentkeimung eingesetzt werden, da sie insbesondere im Wellenlängenbereich von ca. 240 nm bis 270 nm eine antimikrobielle Wirkung hat.

Die erfindungsgemäße Ausführungsform ermöglicht eine gekoppelte Behandlung einer Flüssigkeit mit einem Plasma und mittels UV-Strahlung. So wird eine erhöhte Effektivität der Behandlung der Flüssigkeit ermöglicht.

Gemäß einer Ausführungsform der Erfindung ist vorgesehen, dass mindestens eine Austrittsöffnung des Entladungsraums, aus der die Flüssigkeit aus der Vorrichtung austreten kann, als Sprühdüse oder als Düsenrohr ausgebildet ist oder ein Mittel aufweist, mit dem die Vorrichtung an eine Sprühdüse oder ein Düsenrohr anschließbar ist.

Die als Düsenrohr ausgebildete Austrittsöffnung ermöglicht die Behandlung größerer Areale mit der plasmabehandelten Flüssigkeit. Diese Möglichkeit bietet insbesondere Vorteile für Anwendungen im Gartenbau und im Agrarbereich.

Das Düsenrohr kann dafür auch mit Sprühdüsen ausgerüstet werden, so dass das plasmabehandelte Wasser unter Druck in Form eines Sprühnebels auf größeren Flächen aufgebracht wird.

Ein weiterer Aspekt der Erfindung sieht vor, dass ein System zumindest eine erste und eine zweite Vorrichtung zur Behandlung einer Flüssigkeit aufweist, wobei die erste Vorrichtung mit der zweiten Vorrichtung in Serie angeordnet ist.

Für eine Serienschaltung wird die erste Vorrichtung mit der zweiten Vorrichtung über eine Austrittsöffnung der ersten Vorrichtung und einer Zulauföffnung der zweiten Vorrichtung verbunden.

Weitere Merkmale und Vorteile der Erfindung werden nachfolgend anhand der Figurenbeschreibung von Ausführungsbeispielen erläutert. Es zeigen:
Fig. 1 eine geschnittene Darstellung einer senkrechten Ausführungsform der Vorrichtung, die an einen Wasserhahn angeschlossen ist,
Fig. 2 eine geschnittene Darstellung einer senkrechten Ausführungsform der Vorrichtung, die UV-Strahlungsquellen umfasst und die an einen Wasserhahn angeschlossen ist,
Fig. 3 eine geschnittene Darstellung einer senkrechten Ausführungsform der Vorrichtung, in der die Masseelektrodenvorrichtung ein Metallgewebe und ein Keramikrohr umfasst und die an einen Wasserhahn angeschlossen ist, und
Fig. 4 eine geschnittene Darstellung einer waagerechten Ausführungsform der Vorrichtung, die an einen Wassertank angeschlossen ist.

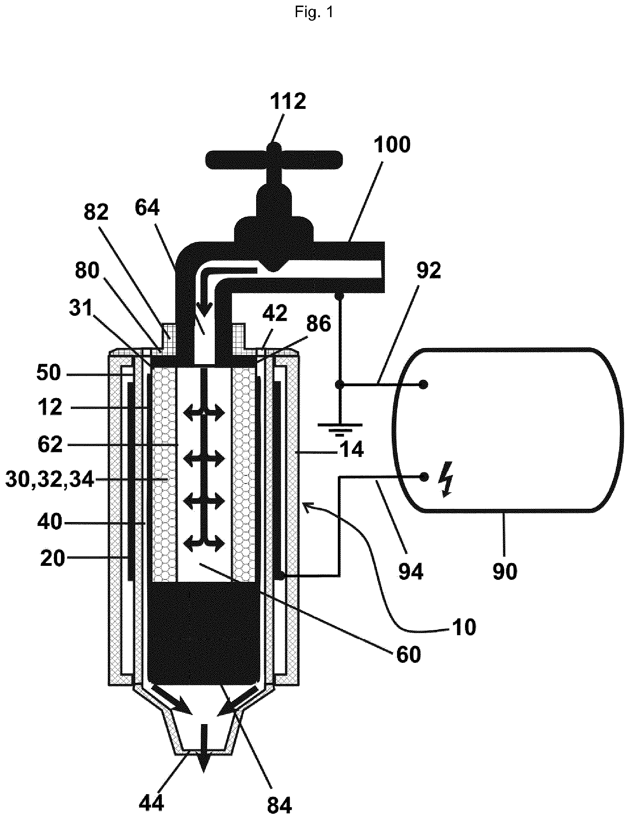

In Figur 1 ist der Aufbau der erfindungsgemäßen Vorrichtung 10 zur Behandlung einer Flüssigkeit mit einem Plasma in aufgeschnittener Darstellung gezeigt. Die Vorrichtung 10 ist mittels eines Anschlusssegmentes 82, das von einer Montageplatte 80 ausgebildet ist, an einem Wasserhahn 100 montiert. Die Montageplatte 80 bildet den oberen Abschluss der Vorrichtung 10 und erstreckt sich über ihre gesamte Oberseite.

Die in Fig. 1 gezeigte Vorrichtung 10 umfasst ein zylindrisch geformtes Vorlaufvolumen 60, in das eine Flüssigkeit 12 aus dem Wasserhahn 100 durch einen Zulauf 64 eingeleitet werden kann. Das Vorlaufvolumen 60 ist durch eine rohrförmig ausgebildete Masseelektrodenvorrichtung 30 begrenzt, d.h. die Wandung 62 des Vorlaufvolumens 60 ist vollständig durch die Masseelektrodenvorrichtung 30 ausgebildet. Die Massenelektrodenvorrichtung 30 ist feinporig und flüssigkeitsdurchlässig. Die Masseelektrodenvorrichtung 30 ist einstückig ausgebildet, d.h. der leitfähige Bereich 32 und der poröse Bereich 34 bestehen aus demselben Material. Koaxial um die Masseelektrodenvorrichtung 30 angeordnet erstreckt sich der Entladungsraum 40, der auf seiner der Masseelektrodenvorrichtung 30 abgewandten Seite durch ein erstes Dielektrikum 50 begrenzt ist. Das erste Dielektrikum 50 ist beispielsweise ein Glasrohr oder ein Quarzglasrohr.

Auf der dem Entladungsraum 40 abgewandten Seite des ersten Dielektrikums 50 ist eine Hochspannungselektrode 20 angeordnet. Die Hochspannungselektrode 20 ist rohrförmig und koaxial zur Masseelektrodenvorrichtung 30 ausgebildet, d.h. die Hochspannungselektrode 20 und die Masseelektrodenvorrichtung 30 liegen einander parallel verlaufend gegenüber. Zwischen ihnen erstreckt sich der Entladungsraum 40. Radial nach außen ist die Hochspannungselektrode 20 von einem Gehäuse 14 umgeben. Das Gehäuse 14 schützt die Vorrichtung 10 gegenüber Berührungen von außen.

Die Vorrichtung 10 kann im Entladungsraum 40 aufgrund der Elektroden-Geometrien ein Plasma erzeugen.

Die Masseelektrodenvorrichtung 30 ist über ein erstes Anschlusskabel 92 mit einer Hochspannungsquelle 90 geerdet verbunden. Ebenso ist die Hochspannungselektrode 20 über ein zweites Anschlusskabel 94 mit der Hochspannungsquelle 90 verbunden, so dass nach dem Einschalten der Hochspannungsquelle 90 eine zwischen den Elektroden 20, 30 anliegende Spannung zur Zündung einer dielektrisch behinderten Volumen-Entladung in dem Entladungsraum 40 führt.

In dem Bereich der Montageplatte 80, der den Entladungsraum 40 nach oben hin begrenzt, befinden sich Arbeitsgasöffnungen 42, durch die ein Arbeitsgas in den Entladungsraum 40 eingeleitet werden kann. Aus dem unteren Bereich des Entladungsraums 40 gelangt die Flüssigkeit 12 durch eine Austrittsöffnung 44 aus der Vorrichtung 10 hinaus.

Das untere Ende des Vorlaufvolumens 60 und der Masseelektrodenvorrichtung 30 ist von einem Endstück 84 aus Vollmaterial begrenzt, das die Flüssigkeit 12 nicht durchdringen kann. Das obere Ende der Masseelektrodenvorrichtung 30 ist von einem Deckring 86 aus Vollmaterial begrenzt. Oberhalb des Deckringes 86 ist die Montageplatte 80 angeordnet.

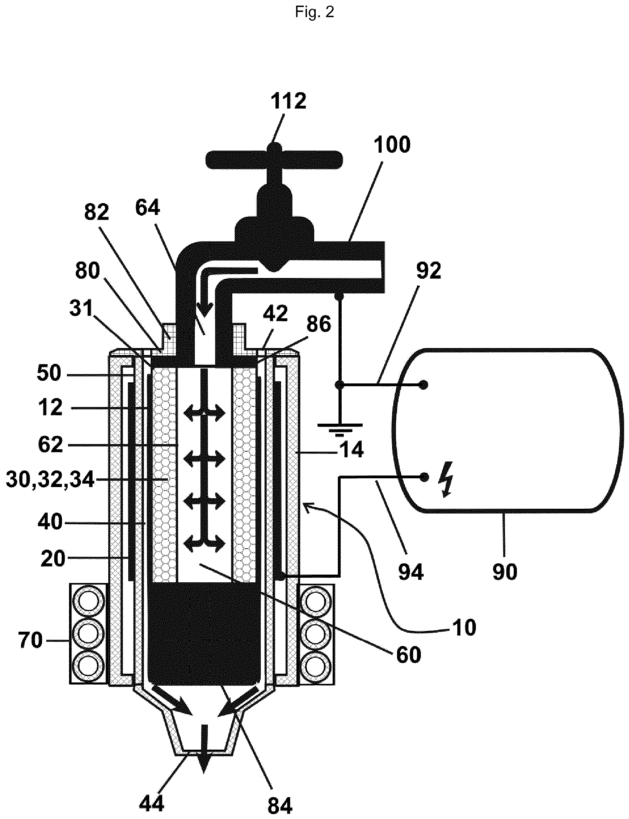

Figur 2 zeigt die erfindungsgemäße Vorrichtung 10 zur Behandlung einer Flüssigkeit mit einem Plasma, die eine UV-Strahlungsquelle 70 aufweist, in aufgeschnittener Darstellung. Die in Fig. 2 dargestellte Vorrichtung 10 gleicht der Vorrichtung 10, die in Fig. 1 gezeigt ist, indem die Vorrichtung 10 in Fig. 2 ebenfalls koaxial aufgebaut ist und in senkrechter Ausrichtung angeordnet ist. Innenliegend befindet sich das Vorlaufvolumen 60, das durch die Masseelektrodenvorrichtung 30 begrenzt ist. Die Masseelektrodenvorrichtung 30 grenzt mit der äußeren Oberfläche 31 an den Entladungsraum 40, der vom ersten Dielektrikum 50 umgeben ist. Das erste Dielektrikum 50 ist von der Hochspannungselektrode 20 umgeben und diese von dem Gehäuse 14. Zusätzlich zu den bereits in Fig. 1 gezeigten Bestandteilen umfasst die in Fig. 2 gezeigte Vorrichtung 10 eine UV-Strahlungsquelle 70. Die UV-Strahlungsquelle 70 ist radial außerhalb des Gehäuses 14 an der Vorrichtung 10 angeordnet. Sie ist in dem Bereich angeordnet, in dem im Inneren der Vorrichtung 10 das Endstück 84 aus Vollmaterial positioniert ist. Das bedeutet, dass die UV-Strahlungsquelle 70 unterhalb der Masseelektrodenvorrichtung 30 und der Hochspannungselektrode 20 angeordnet ist. In dieser Ausführungsform der Vorrichtung 10 ist vorgesehen, dass das Gehäuse 14 zumindest in einem Bereich, der an die UV-Strahlungsquelle 70 angrenzt, aus Quarzglas besteht. Durch diese Ausgestaltung wird ermöglicht, dass die kurzwellige UV-Strahlung nicht durch das Material des Gehäuses 14 absorbiert wird. So bleibt die Wirkung der UV-Strahlung auf die Flüssigkeit 12 erhalten.

In einer alternativen Ausführungsform ist vorgesehen, dass die Vorrichtung 10 derart gestaltet ist, dass die UV-Strahlungsquelle 70 in einen Bereich des Gehäuses 14 integriert ist. Dadurch ist auf einfache Weise verhindert, dass die UV-Strahlung durch das Material des Gehäuses 14 absorbiert wird.

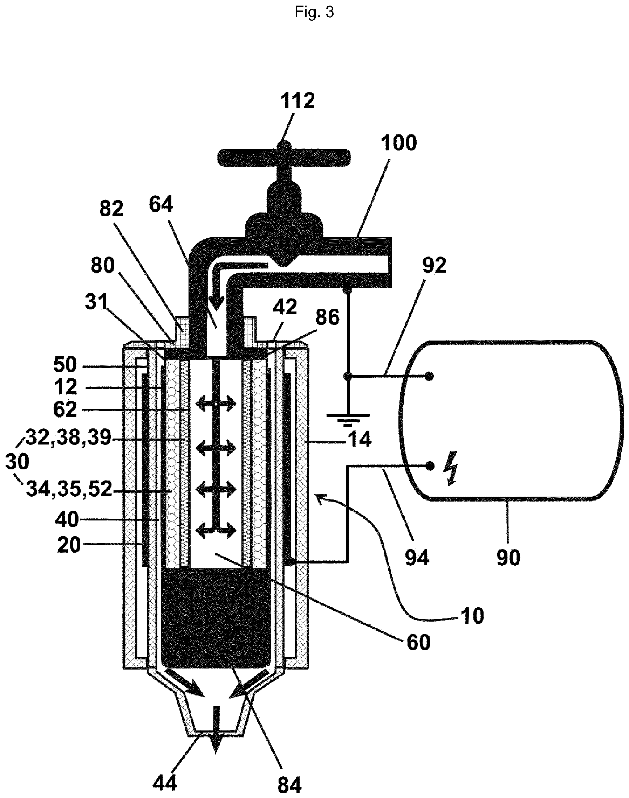

Die in Fig. 3 aufgeschnitten dargestellte Ausführungsform der Vorrichtung 10 ist ebenfalls koaxial ausgebildet.

Zentral weist die Vorrichtung 10 das Vorlaufvolumen 60 auf. Die Masseelektrodenvorrichtung 30 begrenzt das Vorlaufvolumen 60 und umfasst einen leitfähigen Bereich 32 und einen porösen Bereich 34. Der leitfähige Bereich 32 ist durch ein flüssigkeitsdurchlässiges Metallgewebe, das beispielsweise ein leitfähiges Textil 39 oder eine Metallgaze 38 ist, ausgebildet. Das Metallgewebe ist von dem porösen Bereich 34 umgeben, der beispielsweise durch ein Keramikrohr 35 ausgebildet ist. Das Keramikrohr 35 ist porös und somit ebenfalls flüssigkeitsdurchlässig. Das Keramikrohr 35 ist elektrisch nichtleitend und dient als zweites Dielektrikum 52. Mit der dem Vorlaufvolumen 60 abgewandten Seite grenzt das Keramikrohr 35 an den Entladungsraum 40, welcher auf seiner anderen Seite durch das als Glasrohr ausgebildete erste Dielektrikum 50 begrenzt ist. Ein Metallgewebe bildet die radial nach außen an das erste Dielektrikum 50 angrenzende Hochspannungselektrode 20. Ein Acrylrohr bildet das Gehäuse 14, das radial außerhalb der Hochspannungselektrode 20 positioniert ist.

Die oberen Enden der Masseelektrodenvorrichtung 30 und des ersten Dielektrikums 50 sind in der Montageplatte 80 positioniert. Wie bereits in Figur 1 dargestellt, ist das jeweilige untere Ende des Vorlaufvolumens 60 und der Masseelektrodenvorrichtung 30 von einem Endstück 84 aus Vollmaterial begrenzt, durch das die Flüssigkeit 12 nicht dringen kann. Die Flüssigkeit 12 kann aus dem unteren Bereich des Entladungsraums 40 durch eine Austrittsöffnung 44 aus der Vorrichtung 10 hinausgelangen.

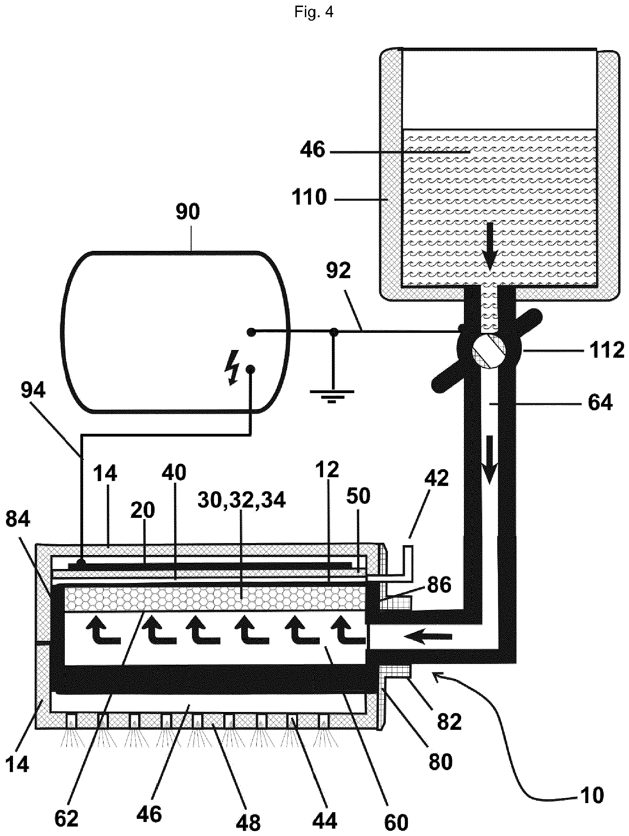

Figur 4 zeigt eine geschnittene Darstellung einer Ausführungsform der Vorrichtung 10, in der die Massenelektrodenvorrichtung 30 plan ausgebildet ist. Die Masseelektrodenvorrichtung 30 ist einstückig ausgeformt. Die Vorrichtung 10 ist waagerecht angeordnet. Das Anschlusssegment 82, durch das die Flüssigkeit 12 aus einem Flüssigkeitstank 110 in das Vorlaufvolumen 60 gelangt, ist seitlich positioniert. Das Anschlusssegment 82 ist von der Montageplatte 80 ausgebildet, die sich über eine ganze Seitenfläche der Vorrichtung 10 erstreckt. Der Zufluss der Flüssigkeit aus dem Flüssigkeitstank 110 in das Vorlaufvolumen 60 wird mittels eines Auslaufventils 112 reguliert.

Der untere Bereich sowie der seitliche Bereich des Vorlaufvolumens 60, der dem Anschlusssegment 82 gegenüberliegt, sind durch Endstücke 84 aus Vollmaterial begrenzt. Der Bereich rund um das Anschlusssegment 82 ist ebenfalls durch Vollmaterial begrenzt. Der obere Bereich des Vorlaufvolumens 60 ist von der plan verlaufenden Masseelektrodenvorrichtung 30 begrenzt. Die Massenelektrodenvorrichtung 30 ist feinporig und flüssigkeitsdurchlässig ausgebildet. Oberhalb der Massenelektrodenvorrichtung 30 befindet sich der Entladungsraum 40, dessen obere Begrenzung durch ein erstes Dielektrikum 50 gebildet ist. An der dem Entladungsraum 40 abgewandten Seite des ersten Dielektrikums 50 ist die Hochspannungselektrode 20 positioniert. Ein Bereich des Gehäuses 14 ist oberhalb der Hochspannungselektrode 20 angeordnet. Das Gehäuse 14 bildet weiterhin eine untere Begrenzung der Vorrichtung 10. Zwischen dem unteren Bereich des Gehäuses 14 und dem unteren Bereich des Vorlaufvolumens 60 erstreckt sich ein Sammelvolumen 46. Der untere Bereich des Entladungsraums 40 endet in dem Sammelvolumen 46. Der untere Bereich des Gehäuses 14 umfasst Austrittsöffnungen 44, die als Sprühdüsen 48 ausgebildet sind. Durch diese gelangt die Flüssigkeit 12 aus dem Sammelvolumen 46 hinaus.

In dem Bereich der Montageplatte 80, der den Entladungsraum 40 an der Seite begrenzt und an der das Anschlusssegment 82 ausgebildet ist, befindet sich eine Arbeitsgasöffnung 42. Durch diese kann ein Arbeitsgas in den Entladungsraum 40 gelangen. Ein Arbeitsgas kann beispielsweise Umgebungsluft sein.

Die Masseelektrodenvorrichtung 30 ist über ein erstes Anschlusskabel 92 mit der Hochspannungsquelle 90 geerdet verbunden. Die Hochspannungselektrode 20 ist über ein zweites Anschlusskabel 94 mit der Hochspannungsquelle 90 verbunden. Nach dem Einschalten der Hochspannungsquelle 90 führt die an den Elektroden 20, 30 angelegte Spannung zur Zündung einer dielektrisch behinderten Entladung in dem Entladungsraum 40, insbesondere zu einer dielektrisch behinderten Volumen-Entladung.

### Bezuaszeichenliste

- 10: Vorrichtung
- 12: Flüssigkeit
- 14: Gehäuse
- 20: Hochspannungselektrode
- 30: Masseelektrodenvorrichtung
- 31: äußere Oberfläche
- 32: leitfähiger Bereich
- 34: poröser Bereich
- 35: Keramikrohr
- 38: Metallgaze
- 39: leitfähiges Textil
- 40: Entladungsraum
- 42: Arbeitsgasöffnung
- 44: Austrittsöffnung
- 46: Sammelvolumen
- 48: Sprühdüse
- 50: erstes Dielektrikum
- 52: zweites Dielektrikum
- 60: Vorlaufvolumen
- 62: Wandung
- 64: Zulauf
- 70: UV-Strahlungsquelle
- 80: Montageplatte
- 82: Anschlusssegment
- 84: Endstück
- 86: Deckring
- 90: Hochspannungsquelle
- 92: erstes Anschlusskabel
- 94: zweites Anschlusskabel
- 100: Wasserhahn
- 110: Flüssigkeitstank
- 112: Auslaufventil

## Patentansprüche

1. Vorrichtung (10) zur Behandlung einer Flüssigkeit (12) mit einem nicht-thermischen Atmosphärendruckplasma, wobei die Vorrichtung (10) folgende Komponenten aufweist:
- eine Hochspannungselektrode (20);
- eine flüssigkeitsdurchlässige Masseelektrodenvorrichtung (30), die einen flächigen, leitfähigen Bereich (32) und einen an dem flächigen, leitfähigen Bereich (32) angeordneten porösen Bereich (34) aufweist;
- einen zwischen der Masseelektrodenvorrichtung (30) und der Hochspannungselektrode (20) ausgebildeten Entladungsraum (40);
- ein erstes Dielektrikum (50), das an der Hochspannungselektrode (20) angeordnet ist, so dass im Entladungsraum (40) ein Plasma mittels dielektrisch behinderter Entladung erzeugbar ist;
- ein von einer Wandung (62) umfasstes Vorlaufvolumen (60), in das die Flüssigkeit (12) einleitbar ist;
wobei die Wandung (62) des Vorlaufvolumens (60) zumindest in einem ersten Bereich die Masseelektrodenvorrichtung (30) aufweist, so dass das Vorlaufvolumen (60) mit dem Entladungsraum (40) über die Masseelektrodenvorrichtung (30) flüssigkeitsdurchlässig verbunden ist;
wobei die Vorrichtung (10) so ausgebildet ist, dass in Betrieb die in das Vorlaufvolumen (60) eingeleitete Flüssigkeit durch die Masseelektrodenvorrichtung dringt und auf eine Oberfläche der Masseelektrodenvorrichtung (30), die dem Entladungsraum (40) zugewandt ist, strömt, so dass sich auf dieser Oberfläche ein Flüssigkeitsfilm ausbildet;
**dadurch gekennzeichnet, dass**
der leitfähige Bereich (32) der Masseelektrodenvorrichtung entlang seiner flächigen Ausdehnung flüssigkeitsdurchlässig ist.

2. Vorrichtung (10) gemäß Anspruch 1, **dadurch gekennzeichnet, dass** der flächige, leitfähige Bereich (32) der Masseelektrodenvorrichtung (30) eine Vielzahl an Ausnehmungen aufweist, die an den porösen Bereich (34) angrenzen.

3. Vorrichtung (10) gemäß einem der Ansprüche 1 bis 2, **dadurch gekennzeichnet, dass** der flächige, leitfähige Bereich (32) der Masseelektrodenvorrichtung (30) eine perforierte oder eine gitterartige oder eine textile Struktur oder eine poröse Struktur aufweist.

4. Vorrichtung (10) gemäß einem der Ansprüche 1 bis 3, **dadurch gekennzeichnet, dass** der flächige, leitfähige Bereich (32) der Masseelektrodenvorrichtung (30) ein elektrisch leitfähiges Textil (39) aufweist oder aus einem elektrisch leitfähigen Textil (39) besteht.

5. Vorrichtung (10) gemäß einem der Ansprüche 1 bis 4, **dadurch gekennzeichnet, dass** der flächige, leitfähige Bereich (32) der Masseelektrodenvorrichtung (30) eine leitfähige Gaze (38) aufweist oder aus der Gaze besteht.

6. Vorrichtung (10) gemäß einem der Ansprüche 1 bis 5, **dadurch gekennzeichnet, dass** der poröse Bereich (34) der Masseelektrodenvorrichtung (30) leitfähig und zumindest leitfähig mit dem leitfähigen Bereich (32) verbunden ist, der leitfähige Bereich (32) und der poröse Bereich (34) aus demselben Material bestehen oder der poröse Bereich (34) und der leitfähige Bereich (32) einstückig in einem zusammenhängenden Stück aus demselben Material ausgebildet sind.

7. Vorrichtung (10) gemäß einem der Ansprüche 1 bis 5, **dadurch gekennzeichnet, dass** der poröse Bereich (34) der Masseelektrodenvorrichtung (30) ein Isoliermaterial (52), insbesondere ein zweites Dielektrikum (52), insbesondere einen kristallinen, teilkristallinen oder einen keramischen Stoff aufweist oder daraus besteht.

8. Vorrichtung (10) gemäß einem der Ansprüche 1 bis 7, **dadurch gekennzeichnet, dass** der poröse Bereich (34) als Flüssigkeitsfilter ausgebildet ist, so dass eine durch den porösen Bereich (34) hindurchtretende Flüssigkeit (12) gefiltert ist.

9. Vorrichtung (10) gemäß einem der Ansprüche 1 bis 8, **dadurch gekennzeichnet, dass** die Wandung (62) des Vorlaufvolumens (60) zylindrisch oder konisch ausgebildet ist, insbesondere wobei die Wandung (62) in einem umlaufenden Bereich des Zylindermantels oder des Konus aus der Masseelektrodenvorrichtung (30) besteht.

10. Vorrichtung (10) gemäß einem der Ansprüche 1 bis 9, **dadurch gekennzeichnet, dass** die Masseelektrodenvorrichtung (30) und die Hochspannungselektrode (20) koaxial angeordnet sind.

11. Vorrichtung (10) gemäß einem der Ansprüche 1 bis 8, **dadurch gekennzeichnet, dass** die Masseelektrodenvorrichtung (30) an einem planaren Bereich der Wandung (62) angeordnet ist, wobei die Masseelektrodenvorrichtung (30) planar ausgebildet ist.

12. Vorrichtung (10) gemäß einem der vorherigen Ansprüche, **dadurch gekennzeichnet, dass** die Vorrichtung (10) eine Arbeitsgasöffnung (42) aufweist, durch die ein gasförmiges Medium in den Entladungsraum (40) geleitet werden kann.

13. Vorrichtung (10) gemäß einem der vorherigen Ansprüche, **dadurch gekennzeichnet, dass** die Vorrichtung (10) eine UV-Strahlungsquelle (70) oder ein Anschlussmittel für eine UV-Strahlungsquelle (70) aufweist, wobei die UV-Strahlungsquelle (70) derart positioniert oder über das Anschlussmittel positionierbar ist, dass die UV-Strahlung auf die Flüssigkeit (12) trifft.

14. Vorrichtung (10) gemäß einem der vorherigen Ansprüche, **dadurch gekennzeichnet, dass** die Vorrichtung (10) zumindest eine Austrittsöffnung (44) des Entladungsraums (40) aufweist, aus der Flüssigkeit (12) aus der Vorrichtung (10) austreten kann, wobei die mindestens eine Austrittsöffnung (44) als Sprühdüse (48) oder als Düsenrohr ausgebildet ist oder ein Mittel aufweist, mit dem die Vorrichtung (10) an eine Sprühdüse oder ein Düsenrohr anschließbar ist.

15. System zur Behandlung einer Flüssigkeit mit einem Plasma, **dadurch gekennzeichnet, dass** das System zumindest eine erste und eine zweite Vorrichtung (10) zur Behandlung einer Flüssigkeit (12) gemäß einem der vorherigen Ansprüche aufweist, wobei die erste Vorrichtung (10) mit der zweiten Vorrichtung (10) in Serie angeordnet ist.

## Claims

1. Device (10) for treatment of a liquid (12) with a non-thermal atmospheric pressure plasma, wherein the device (10) comprises the following components:
- a high-voltage electrode (20);
- a liquid-permeable ground electrode device (30) comprising an areal, conductive region (32) and a porous region (34) arranged at the areal, conductive region (32);
- a discharge space (40) formed between the ground electrode device (30) and the high-voltage electrode (20);
- a first dielectric (50) which is arranged at the high-voltage electrode (20) such that a plasma can be generated in the discharge space (40) by means of a dielectric-barrier discharge;
- a flow volume (60) comprised by a wall (62) into which the liquid (12) can be fed;
wherein
the wall (62) of the flow volume (60) comprises at least in a first region the ground electrode device (30), such that the flow volume (60) is connected liquid-permeably to the discharge space (40) via the ground electrode device (30);
wherein the device (10) is formed such that, in use, the liquid fed into the flow volume (60) passes through the ground electrode device and pours onto a surface of the ground electrode device (30) that faces the discharge space (40), so that a liquid film is formed on said surface;
**characterized in that**
the conductive region (32) of the ground electrode device is liquid-permeable along its areal expansion.

2. Device (10) according to claim 1, **characterized in that** the areal, conductive region (32) of the ground electrode device (30) comprises a plurality of recesses that adjoin the porous region (34).

3. Device (10) according to one of the claims 1 to 2, **characterized in that** the areal, conductive region (32) of the ground electrode device (30) comprises a perforated, or a grid-like, or a textile structure, or a porous structure.

4. Device (10) according to one of the claims 1 to 3, **characterized in that** the areal, conductive region (32) of the ground electrode device (30) comprises an electrically conductive textile (39) or consists of an electrically conductive textile (39).

5. Device (10) according to one of the claims 1 to 4, **characterized in that** the areal, conductive region (32) of the ground electrode device (30) comprises a conductive gauze (38) or consists of the gauze.

6. Device (10) according to one of the claims 1 to 5, **characterized in that** the porous region (34) of the ground electrode device (30) is conductive and at least conductively connected to the conductive region (32), the conductive region (32), that the porous region (34) consists of the same material, or that the porous region (34) and the conductive region (32) are integrally formed in one contiguous piece from the same material.

7. Device (10) according to one of the claims 1 to 5, **characterized in that** the porous region (34) of the ground electrode device (30) comprises or consists of an insulating material (52), particularly a second dielectric (52), particularly a crystalline, partially crystalline or ceramic material.

8. Device (10) according to one of the claims 1 to 7, **characterized in that** the porous region (34) is formed as a liquid filter so that a liquid (12) passing through the porous region (34) is filtered.

9. Device (10) according to one of the claims 1 to 8, **characterized in that** the wall (62) of the flow volume (60) is formed cylindrically or conically, particularly wherein the wall (62) consists of the ground electrode device (30) in a circumferential region of the cylinder mantle or the cone.

10. Device (10) according to one of the claims 1 to 9, **characterized in that** the ground electrode device (30) and the high-voltage electrode (20) are arranged coaxially.

11. Device (10) according to one of the claims 1 to 8, **characterized in that** the ground electrode device (30) is arranged at a planar region of the wall (62), wherein the ground electrode device (30) is formed planarly.

12. Device (10) according to one of the preceding claims, **characterized in that** the device (10) comprises a working gas opening (42) through which a gaseous medium can be directed into the discharge space (40).

13. Device (10) according to any of the preceding claims, **characterized in that** the device (10) comprises a UV-radiation source (70) or a connection means for a UV-radiation source (70), wherein the UV-radiation source (70) is positioned or positionable by means of the connection means such that the UV-radiation impinges onto the liquid (12).

14. Device (10) according to one of the preceding claims, **characterized in that** the device (10) comprises at least one outlet opening (44) of the discharge space (40) from which liquid (12) can exit the device (10), wherein the at least one outlet opening (44) is formed as a spray nozzle (48), or as a nozzle pipe, or comprises a means by which the device (10) can be connected to a spray nozzle or a nozzle pipe.

15. System for treatment of a liquid with a plasma, **characterized in that** the system comprises at least a first and a second device (10) for treatment of a liquid (12) according to one of the preceding claims, wherein the first device (10) is arranged in series with the second device (10).

## Revendications

1. Dispositif (10) pour le traitement d'un liquide (12) avec un plasma à pression atmosphérique non thermique, le dispositif (10) présentant les composants suivants :
- une électrode à haute tension (20) ;
- un dispositif d'électrode de masse (30) perméable au liquide, lequel présente une région plate conductrice (32) et une région poreuse (34) disposée sur la région plate conductrice (32) ;
- un espace de décharge (40) formé entre le dispositif d'électrode de masse (30) et l'électrode à haute tension (20) ;
- un premier diélectrique (50) disposé sur l'électrode à haute tension (20), de manière à pouvoir produire un plasma dans l'espace de décharge (40) par décharge à barrière diélectrique ;
- un volume de départ (60) délimité par une paroi (62), dans lequel le liquide (12) peut être introduit ;
dans lequel la paroi (62) du volume de départ (60) présente le dispositif d'électrode de masse (30) au moins dans une première région, de telle façon que le volume de départ (60) est relié de manière perméable au liquide à l'espace de décharge (40) par le biais du dispositif d'électrode de masse (30) ;
dans lequel le dispositif (10) est conçu de telle façon que pendant le fonctionnement, le liquide introduit dans le volume de départ (60) traverse le dispositif d'électrode de masse et afflue sur une surface du dispositif d'électrode de masse (30), laquelle est tournée vers l'espace de décharge (40), de sorte qu'un film de liquide se forme sur cette surface ;
**caractérisé en ce que**
- la région conductrice (32) du dispositif d'électrode de masse est perméable au liquide le long de son extension plate.

2. Dispositif (10) selon la revendication 1, **caractérisé en ce que** la région plate conductrice (32) du dispositif d'électrode de masse (30) présente une multitude d'évidements, lesquels sont adjacents à la région poreuse (34) .

3. Dispositif (10) selon l'une des revendications 1 à 2, **caractérisé en ce que** la région plate conductrice (32) du dispositif d'électrode de masse (30) présente une structure perforée ou du genre grille ou textile ou une structure poreuse.

4. Dispositif (10) selon l'une des revendications 1 à 3, **caractérisé en ce que** la région plate conductrice (32) du dispositif d'électrode de masse (30) présente un textile électriquement conducteur (39) ou consiste en un textile électriquement conducteur (39).

5. Dispositif (10) selon l'une des revendications 1 à 4, **caractérisé en ce que** la région plate conductrice (32) du dispositif d'électrode de masse (30) présente une gaze conductrice (38) ou consiste en une gaze conductrice.

6. Dispositif (10) selon l'une des revendications 1 à 5, **caractérisé en ce que** la région poreuse (34) du dispositif d'électrode de masse (30) est reliée de façon conductrice et au moins conductrice à la région conductrice (32), la région conductrice (32) et la région poreuse (34) sont constituées du même matériau ou la région poreuse (34) et la région conductrice (32) sont réalisées d'un seul tenant à partir d'une pièce continue du même matériau.

7. Dispositif (10) selon l'une des revendications 1 à 5, **caractérisé en ce que** la région poreuse (34) du dispositif d'électrode de masse (30) présente ou consiste en un matériau isolant (52), en particulier un deuxième diélectrique (52), en particulier une matière cristalline, partiellement cristalline ou céramique.

8. Dispositif (10) selon l'une des revendications 1 à 7, **caractérisé en ce que** la région poreuse (34) est conçue comme un filtre à liquide, de manière à filtrer un liquide (12) s'écoulant à travers la région poreuse (34).

9. Dispositif (10) selon l'une des revendications 1 à 8, **caractérisé en ce que** la paroi (62) du volume de départ (60) est conçue de manière cylindrique ou conique, la paroi (62) consiste en particulier dans le dispositif d'électrode de masse (30) dans une région périphérique de l'enveloppe de cylindre ou du cône.

10. Dispositif (10) selon l'une des revendications 1 à 9, **caractérisé en ce que** le dispositif d'électrode de masse (30) et l'électrode à haute tension (20) sont disposés coaxialement.

11. Dispositif (10) selon l'une des revendications 1 à 8, **caractérisé en ce que** le dispositif d'électrode de masse (30) est disposé sur une région planaire de la paroi (62), le dispositif d'électrode de masse (30) étant conçu de manière planaire.

12. Dispositif (10) selon l'une des revendications précédentes, **caractérisé en ce que** le dispositif (10) présente un orifice de gaz de travail (42), par lequel un fluide gazeux peut être conduit dans l'espace de décharge (40).

13. Dispositif (10) selon l'une des revendications précédentes, **caractérisé en ce que** le dispositif (10) présente une source de rayonnement ultraviolet (70) ou un moyen de raccordement pour une source de rayonnement ultraviolet (70), la source de rayonnement ultraviolet (70) étant positionnée ou pouvant être positionnée par le biais du moyen de raccordement de manière à ce que le rayonnement ultraviolet rencontre le liquide (12).

14. Dispositif (10) selon l'une des revendications précédentes, **caractérisé en ce que** le dispositif (10) présente au moins un orifice de sortie (44) de l'espace de décharge (40), par lequel du liquide (12) peut sortir du dispositif (10), l'au moins un orifice de sortie (44) étant conçu comme une buse de pulvérisation (48) ou comme un tube de buse ou présentant un moyen permettant de raccorder le dispositif (10) à une buse de pulvérisation ou à un tube de buse.

15. Système de traitement d'un liquide avec un plasma, **caractérisé en ce que** le système présente au moins un premier et un deuxième dispositif (10) pour le traitement d'un liquide (12) selon l'une des revendications précédentes, dans lequel le premier dispositif (10) est disposé en série avec le deuxième dispositif (10).
